# EUROPEAN PATENT SPECIFICATION

(11) **EP 2 209 165 B1**
(45) Date of publication and mention of the grant of the patent: **20.06.2012**
(21) Application number: 09150861.4
(22) Date of filing: 19.01.2009
(51) Int. Cl.: H01R 12/51, H01R 12/77, H01R 12/71

(54) **Assembly for foolproof mechanical and electrical connectivitiy between conductors**
Anordnung zur betriebssicheren mechanischen und elektrischen Konnektivität zwischen Leitern
Assemblage pour connectivité mécanique et électrique indéréglable entre des conducteurs

(43) Date of publication of application: 21.07.2010
(73) Proprietor: Erea NV, 2110 Wijnegem (BE)
(72) Inventor: Totté, Lieven, 9140 Elversele (BE)
(74) Representative: D'Halleweyn, Nele Veerle Trees Gertrudis

(56) References cited:
- EP-A- 1 583 178
- WO-A-98/34298
- WO-A-2007/131537
- GB-A- 2 361 988

## Description

### Field of the Invention

The present invention generally relates to foolproof mechanical and electrical connection of conductors. Examples are board-to-board connections, like for instance connections between LED strips equipped with LED chips of multi-colour LEDs (Light Emitting Diodes), and board-to-wire connections, like for instance connections between LED strips and electrical power wires. Within the context of this patent application, the mechanical connection of conductors involves maintaining the conductors in relative position such that they cannot move relative to each other (except for small movements within certain tolerance boundaries), and avoiding that the conductors can be pulled apart in axial direction.

### Background of the Invention

In general two different state-of-the-art methods for connecting conductors can be distinguished. The first method relies on wiring for electrical interconnection of conductors. Such wiring usually does not provide mechanical interconnectivity. The second method relies on connectors for mechanical and electrical interconnection of conductors. In the following paragraphs, examples of existing solutions of these two categories will be described, as well as their drawbacks resolved by the present invention.

The TALEXXstrip ES from Tridonic.Atco is a range of LED based light strips for lit sign applications. Each LED strip consists of a PCB whereon high power LEDs are equidistantly spaced. In order to form longer light strips, the LED strips can be connected together through wires that are soldered onto the PCBs. The TALEXXstrip ES range is for instance described in Data Sheet 03/08-761-0 from Tridonic.Atco that can be downloaded from the Internet at the following URL:
http://www.tridonicatco.com/kms/media/uploads/talexxstrip_es_en.pdf Further state-of-the-art LED light chains from Tridonic.Atco are for instance advertised in the news article "Brilliant Highlights at Light + Building" published on the Internet at the URL: http://www.tridonic.co.at/kms/cms/kms.php?id=1791&str_id=2949&det_back=1 Herein, the picture illustrating the P515 LED light chains clearly show the wires interconnecting plural LED modules each holding three LEDs.

The known way of connecting LED strips based on soldering wires by a technician in the field, is cumbersome and time consuming for the technician that has to install the LED strips. The LED strips may have been fixed onto a surface via screws or adhesive pads in which case the LED strips are difficult to reach or access with a soldering tool. In the reverse order where the LED strips are first soldered together, the fixing of several series connected or parallel connected LED strips onto a surface is difficult if not impossible for a single technician.

An additional drawback of connecting LED strips as prescribed by Tridonic.Atco is that the LED strips may be interconnected erroneously by soldering the wires onto wrong contacts on the PCBs. This known way of connecting and installing LED strips in other words is prone to errors and therefore not foolproof.

The wire-based interconnection of LED strips further is disadvantageous in that the wires create gaps in between the LED strips, which results in uneven light intensities along a series connection of LED strips. The LEDs are no longer equidistantly spaced as a result of which dark spots or zones with lower light intensity are created near the edges of the LED strips. This effect is even worse when a second or additional power module has to be installed in between a series of LED strips. The Data Sheet 03/08-761-0 of Tridonic.Atco for instance mentions that a maximum of two LED strips can be connected in series to the EM powerLED module. As a consequence, an additional power module has to be installed to power every sequential set of two LED strips, creating a light pattern with dark spots.

In case of malfunctioning or defect of one of the LEDs, the malfunctioning LED strip interconnected with soldered wires, will be difficult to repair or replace.

An alternative state-of-the-art way of interconnecting LED strips makes use of dedicated connectors like the one used to connect the DM 550224 multi-colour LED strips from DM Lights and shown on the Internet at URL:
http://www.dmlights.com/en/cat/2518/DM%20LightslEclairage%20décorative/L ED%20Stips%20Multi%20Colour/product/DM+550224.html

Whereas such connector seems to be dimensioned to avoid dark spots or zones with reduced light intensity near the edges of the LED strips, installation of the connector is still rather cumbersome and may involve soldering or axially sliding the conductors into the connector. Where additional power units have to be installed to avoid power drop and light intensity fluctuations along the connected LED strips, the equal distance between neighbouring LEDs will not be respected such that spots with reduced light intensity will anyhow be unavoidable near such additional power unit. When flipped or rotated 180 degrees during installation, the LED strips may be erroneously connected through the connector, possibly causing damage to the LEDs. The known connector in other words still does not guarantee correct and foolproof installation. Further, the known connectors typically are rather large (e.g. requiring a minimum distance of 40 mm between neighbouring LEDs on a LED strip) and do not provide mechanical connectivity, since the conductors can be pulled apart in axial direction. Lastly, removing, repairing and/or replacing a LED strip in case of a defect remains difficult since the connector must be dismounted from the LED strips, and the defect LED strip that is glued or screwed onto a surface, must be dismounted thereafter. For evident reasons, this involves a technician, is time consuming, requires dedicated tools, and implies risk for damage to the connector or LED strips. In case of a series connection of LED strips, all LED strips up to the defect one may have to be dismounted before the defect LED strip can be dismounted. The LED strips in other words have to be dismounted one-by-one in case of a defect.
DE202008002116U1 describes an optical sensor to detect objects in an observation zone including an assembly according to the preamble of claim 1. The optical sensor has two circuit boards having sensor components attached to them. The two circuit boards can be connected with each other by means of fasteners or connecting elements. The connecting elements have contacts which when placed in position provide for an electric connection with contact surfaces of the circuit boards. However, the arrangement does not guarantee correct and foolproof installation, since the protrusions and corresponding holes are of the same shape on both sides of the circuit boards and connecting element. It is thus easy to wrongfully connect the two circuit boards to each other.

It is an objective of the present invention to provide an assembly enabling to connect conductors such as LED strips without the above described drawbacks of existing solutions. In particular, it is an objective to provide an assembly that enables foolproof installation and electrical and mechanical connection of conductors, mounting and demounting the conductors through a movement or force substantially perpendicular to the axes of the conductors to enable easy repair, replacement or demounting of conductors without the need for tools and risk for damage. It is a further objective to provide an assembly which, when used to interconnect LED strips, provides full flexibility in board-to-board and board-to-wire connectivity, and which enables equidistant LED positioning such that dark spots or zones with reduced light intensity are avoided.

### Summary of the Intention

According to the present invention, the above mentioned drawbacks of the prior art are overcome and the above mentioned objectives are realized through an assembly as defined by claim and a method as defined in claim 11, the assembly as defined by claim 1 comprising:
- a first conductor and a second conductor; and
- a connector which provides electrical and mechanical connectivity between the first conductor and the second conductor,
characterized in that the assembly further comprises a clip adapted to position at least the first conductor and adapted to maintain at least the first conductor in position, the conductor being adapted to engage with the clip; and wherein at least one of the clip, the connector and the conductors have an asymmetric structure adapted to foolproof position and connect the first conductor and the second conductor.

Indeed, thanks to the asymmetric structure of the clip, the first conductor and the second conductor can only be positioned such that they are connected correctly by the connector. In case of a defect the connector can be dismounted manually by opening the clip. No dedicated tools are needed. The clip and connector enable to mount the conductors through a simple movement or force, substantially perpendicular to the axis of the conductors and the surface whereon the conductors are mounted. The demounting is done through opening the clip left and right. A defect conductor or part can be removed, repaired and/or replaced without risk for damage because the connectors themselves no longer have to be fixed (glued or screwed) onto the surface. Instead, the clip can be mounted onto the surface. As will be explained in further detail below, the connector can be a board-to-board connector or a board-to-wire connector engaging with the same clip. Thus, full flexibility is provided in adding PCBs such as LED strips, or wire connections such as power wiring.

It is noticed that the clip in the assembly according to the present invention assists in maintaining the first conductor and eventually also the second conductor in position, thereby enabling installation without tools. The clip holds the first conductor in position during installation of a power module and connection of the first conductor to the power wiring. The clip also holds the first and second conductor in relative position, avoiding that the conductors move during installation (except for small movements within mechanical tolerance boundaries), as a result of which the assembly according to the present invention satisfies safety norms like for instance German safety specification EN 62031, a standard that specifies general and safety requirements for light-emitting diode (LED) modules.

In addition to the assembly defined by claim 1, the present invention concerns a method for foolproof connecting a first conductor and a second conductor, as defined by claims 11, the method including the following steps:
- providing a clip;
- positioning at least the first conductor in the clip;
- maintaining at least the first conductor in position through the clip; and
- engaging a connector with the clip thereby providing mechanical and electrical connectivity between the first conductor and a second conductor,
wherein at least one of the clip, the connector and the conductors have an asymmetric structure for foolproof positioning and connecting the first conductor and the second conductor.

Further optionally, as defined by claim 2, in the assembly according to the present invention,
- the first conductor may be a first Light Emitting Diode strip or first LED strip;
- the second conductor may be a second Light Emitting Diode or second LED strip; and
- the clip, the first LED strip and the second LED strip may be adapted to foolproof position both the first LED strip and the second LED strip and may be adapted to maintain both the first LED strip and the second LED strip (4) in position.

Indeed, as already indicated in the introductory part of this patent application, the conductors to be connected may be LED strips in order to form a longer strip or more complex pattern of LED lights. When the two conductors are LED strips, the clip according to the present invention enables to position both LED strips in order to be foolproof connected thereby avoiding damage to the LED strips. In addition, the clip according to the present invention shall hold both LED strips in position during installation. This way, the installation can be done by a single person who does not need dedicated tools during the installation.

Alternatively, as described by claim 3, in the assembly according to the present invention:
- the first conductor may be a first Light Emitting Diode strip or first LED strip; and
- the second conductor may comprise electrical power wires.

Thus, instead of a board-to-board connector as required to connect two LED strips, the connector may be a board-to-wire connector realizing the connection between a LED strip and power wiring for the LED strip. The fact that additional powering can be provided near any LED strip border, provides full flexibility. The number of LED strips that can be series connected this way becomes virtually unlimited, whereas an even light intensity can be guaranteed along the entire LED pattern because any two successive LEDs will be placed at equal distance irrespective of the amount of LED strips and amount of power modules involved.

A further option of the assembly according to the present invention that comprises the first and/or second LED strips is that the first LED strip and said second LED strip may comprise one or more visible marks indicative for one or more cutting sections, as defined by claim 4.

This way, the LED strips can be cut with a cutting nipper on or near the visible marks. The visible marks may in their simplest form be dashed or dotted lines printed on the LED strips to mark the position where the LED strips are to be cut before installation. In more advanced embodiments, the visible marks may consist of two parallel lines (eventually dotted or dashed) to indicate the zone wherein the LED strips are to be cut, or the visible marks may have an arrow shape, oval shape, round shape, etc. in which case the marks not only indicate where the LED strips have to be cut but also provide a direction wherein two LED strips have to be connected together by the clip and connector according to the invention. The visible marks in other words may further assist in foolproof connecting two LED strips. The visible marks may be either printed on the LED strips, or they may represent a break line of small perforations through the LED strips.

A further advantageous option of the assembly according to the present invention is that the connector preferably has a length that is smaller than the distance between neighbouring LEDs on the first LED strip and the second LED strip. This option is defined by claim 5.

This way, an equal distance can be respected between neighbouring LEDs, also where two LED strips are connected and a connector is placed between the two neighbouring LEDs. An advantage thereof is that the light intensity will be even and no dark spots or zones with lower light intensity will occur.

Another option, described by claim 6, is that the assembly may comprise means for mounting the clip on a surface.

The means for mounting the clip may be a hole for holding a screw or nail, a surface for applying glue or an alternative adhesive, double sided tape, etc. An advantage of this embodiment of the present invention, is that the technician can position the LED strips in the clip and then fix the clip onto the surface. This way, manual installation is simplified. A further advantage is that upon defect of a LED, the LED strip containing the defect LED can be removed, repaired or replaced easily because the LED strip itself is no longer fixed to the surface. The clip can remain in position, fixed to the surface. Only the connector has to be demounted by opening the clip. Thereafter, the LED strip can be removed from the clip holding it and repaired or replaced by another LED strip.

As defined by claim 7, the clip and connector of the assembly according to the present invention preferably are adapted to engage and disengage manually, without tools.

The clip may for instance be made in such a way that it can be opened left and right manually whereby the connector is automatically demounted. The mounting only requires a movement or force substantially perpendicular to the axis of the conductors and substantially perpendicular to the surface whereon the conductors are mounted.

Yet another optional feature, defined by claim 8, is that the clip may be made of a rigid material such as spring steel.

Spring steel is advantageous as material for the clip because it allows to click-in the connector with a normal, human physical force. A spring steel clip provides a strong coupling between the LED strips, and it does not constitute a thermal isolator for the aluminium prints holding power LEDs (in case power LED strips are to be connected). Spring steel does not have a decreasing contact force. In other words, there is no creepage or deformation under load.

Another option, defined by claim 9, is that the clip comprises:
- a bottom plate;
- a first side wall with first recess for positioning the first conductor; and
- a second side wall with second recess for positioning the first conductor,
wherein the first side wall and the second side wall have different sizes or geometries.

Thus, the asymmetry in the clip may be realized through the size or geometry of the side walls of the clip.

As defined by claim 10, the first conductor may comprises a substrate with first cut-out and opposing second cut-out, the first cut-out and second cut-out having different sizes or geometries.

This way, the substrates of the conductors are asymmetric through cut-outs with different size or geometry. The size or geometry of the cut-outs in the conductor substrates preferably match with the recesses in the side-walls of clip hence ensuring foolproof connection of the LED strips.

### Brief Description of the Drawings

Fig. 1 illustrates a first embodiment of the assembly according to the present invention comprising a clip 1, a board-to-board connector 2, and two LED strips 3 and 4;

Fig. 2 illustrates the positioning of conductors 3 and 4 in clip 1 in the embodiment of Fig. 1;

Fig. 3A and Fig. 3B are sectional views of the clip 1, connector 2 and conductors 3 and 4 in the embodiment of Fig. 1;

Fig. 4 illustrates a second embodiment of the assembly according to the present invention comprising a clip 51, a board-to-wire connector 52, a LED strip 53 and electrical power wiring 54;

Fig. 5 illustrates the second embodiment of Fig. 4 after being mounted;

Fig. 6 illustrates a series connection of LED strips wherein the first embodiment of Fig. 1 and the second embodiment of Fig. 4 are both used; and

Fig. 7 illustrates a third embodiment of the assembly according to the present invention comprising a symmetric clip, a board-to-board connector, and two LED strips with arrow-shaped break or cut lines.

### Detailed Description of Embodiment(s)

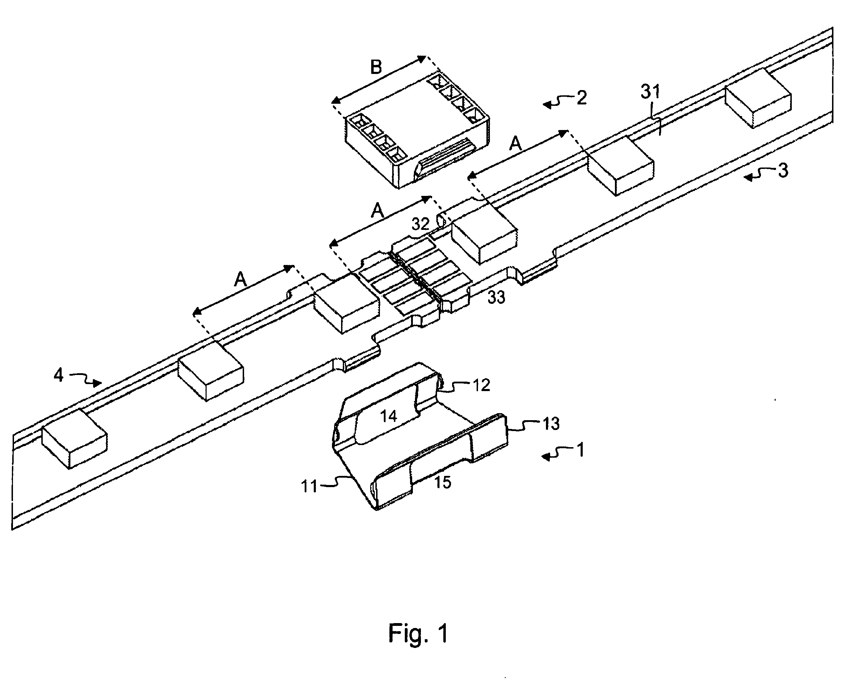

Fig. 1 shows an assembly consisting of two LED strips 3 and 4, a clip 1 and a board-to-board connector 2. The LED strips 3 and 4 each have 4 LEDs equidistantly spaced along the PCB whereon they are mounted. In Fig. 1, only 3 LEDs of LED strip 3 and 3 LEDs of LED strip 4 are shown. The LEDs closest to the border of respectively LED strip 3 and 4 are positioned such that when the LED strips 3 and 4 are brought into connection, the space A between these two LEDs corresponds with the space A between neighbouring LEDs on LED strip 3 or LED strip 4. The LEDs are RGB LEDs and the PCBs whereon they are mounted, e.g. PCB 31 of LED strip 3, have four parallel conductors respectively conveying the R, G, B and ground voltage levels for the LEDs. These four parallel conductors terminate on 4 conductive pads near the LED strip border. The pads are shown in Fig. 1 as rectangles. The clip 1 has a bottom plate 11, first side wall 12 with recess 14 and second side wall 13 with recess 15. The bottom plate 11 may be provided with double-sided tape, or the assembly may contain some double-sided tape.

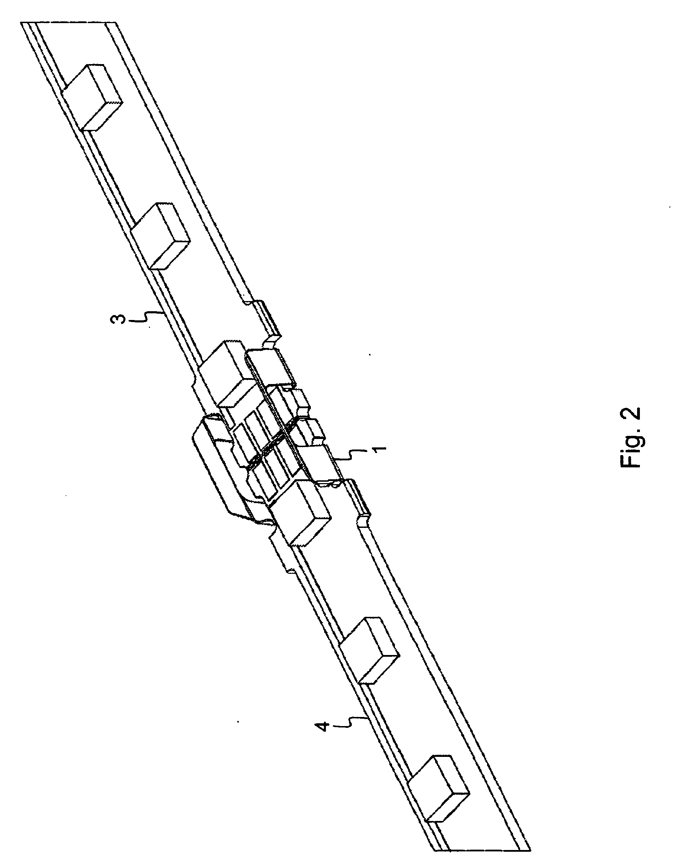

In order to series connect the LED strips 3 and 4 and to mount them on a surface, the installer first provides LED strip 3 with a clip at each respective end. The installer now fixes LED strip 3 on the surface through for instance double-sided tape on the two clips. Thereafter, the LED strip series is increased by positioning LED strip 4 in clip 1, providing an additional clip at the open end of LED strip 4, and fixing LED strip 4 on the surface by taping the additional clip onto the surface. This is illustrated by Fig. 2. LED strip 3 for instance is positioned such that recess 32 in substrate 31 surrounds side wall 12 of clip 1 and recess 33 in substrate 31 surrounds side wall 13 of clip 1. The recesses 32 and 33 have a different length and the side walls 12 and 13 have corresponding different sizes such that it is impossible for the installer to fit LED strip 3 in clip 1 after flipping or rotating LED strip 3 over 180 degrees. Similarly, the substrate of LED strip 4 is provided with asymmetric recesses, i.e. recesses of different size, such that LED strip 4 can be foolproof positioned in clip 1. After having positioned LED strip 3 and LED strip 4 in clip 1, the contact pads of LED strip 3 and LED strip 4 will correctly face each other, i.e. the R contact pads of LED strips 3 and 4 face each other, the G contact pads of LED strips 3 and 4 face each other, the B contact pads of LED strips 3 and 4 face each other, and the ground contact pads of LED strips 3 and 4 face each other. Thanks to the recesses 14 and 15 in the side walls 12 and 13 of clip 1, the LED strips 3 and 4 are held in position during the further installation process. This is shown in Fig. 2. If additional LED strips have to be series or parallel connected with LED strips 3 and 4, the installer may repeat the foregoing steps for each additional LED strip: foolproof positioning the contact pads of neighbouring LED strips in the clip, maintaining the LED strips in position through the recesses in the clip and LED strip substrates, and fixing a clip onto the surface.

Whereas the foregoing paragraph describes the installation procedure of LED strips using double-sided tape, it is noticed that the mounting procedure can alternatively be tape-less when the clips are for instance mounted in a profile, or when screws, glue, or other fixing means are used.

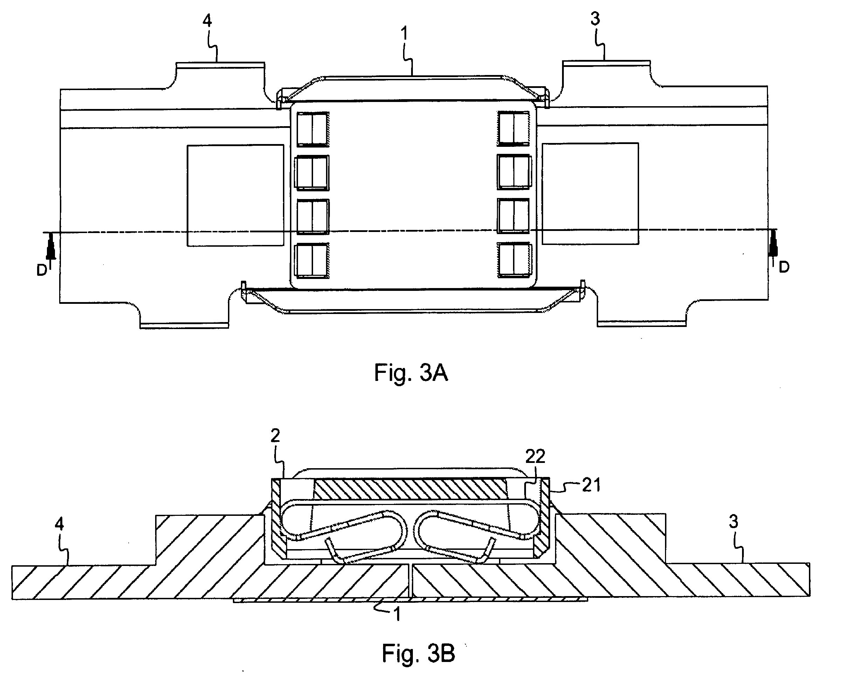

Next, the LED strips 3 and 4 will be mechanically and electrically interconnected by engaging connector 2 with clip 1. A cross section of this connector 2 is shown in Fig. 3B. The cross section is made along line D drawn in Fig. 3A, and shows the housing 21 of connector 2 and one of the spring contacts, i.e. spring contact 22 which will interconnect the third contact pad on LED strip 3 with the third contact pad on LED strip 4. Obviously, the connector 2 contains 4 spring contacts identical to spring contact 22, in order to electrically interconnect the corresponding contact pads of LED strip 3 and LED strip 4. The housing 22 of connector 2 further has two side protrusions that engage with the recesses 14 and 15 in the side walls 12 and 13 of clip 1, and ensure mechanical connectivity between the LED strips 3 and 4, clip 1 and the connector 2. These protrusions are dimensioned to click into the recesses 14 and 15 after having positioned the LED strips, and maintain the components of the assembly in tight mechanical connection with each other such that the LED strips and connector do not slide or move relatively to each other (except for small relative movements within mechanical tolerance boundaries).

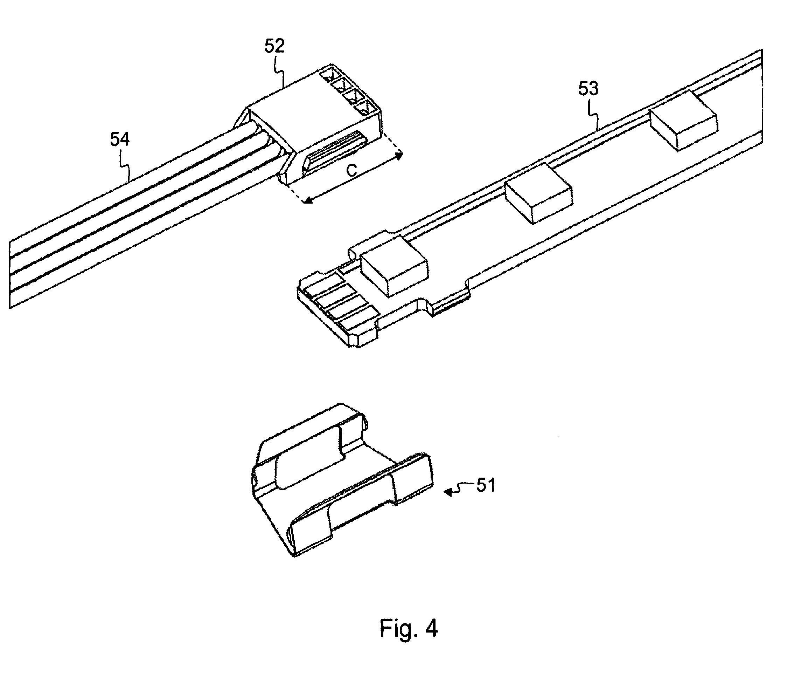

Fig. 4 shows a second assembly in accordance with the present invention, which can be used in the same application, i.e. the interconnecting of LED strips. This second assembly contains a LED strip 53, a clip 51 and a connector 52. Fig. 4 further shows electrical power wiring 54 which may or may not form part of the assembly.

Similar to the assembly of Fig. 1, the installation starts with fixing the clip 51 onto the surface where the LED strip 53 has to be mounted against. Thereto, the installer uses double-sided tape that is already present on the bottom of clip 51 or that is provided with the assembly. Next, the installer manually positions the LED strip 53 into clip 51. In order to foolproof position the LED strip 53 into clip 51, the LED strip substrate is provided with two opposing recesses of different size near the connection pads, and the clip 51 is provided with the side walls of different size, corresponding with the recesses in the LED strip substrate. Thanks to the recesses in the LED strip substrate and the clip side walls, the LED strip 53 is held in position during the remainder of the installation process.

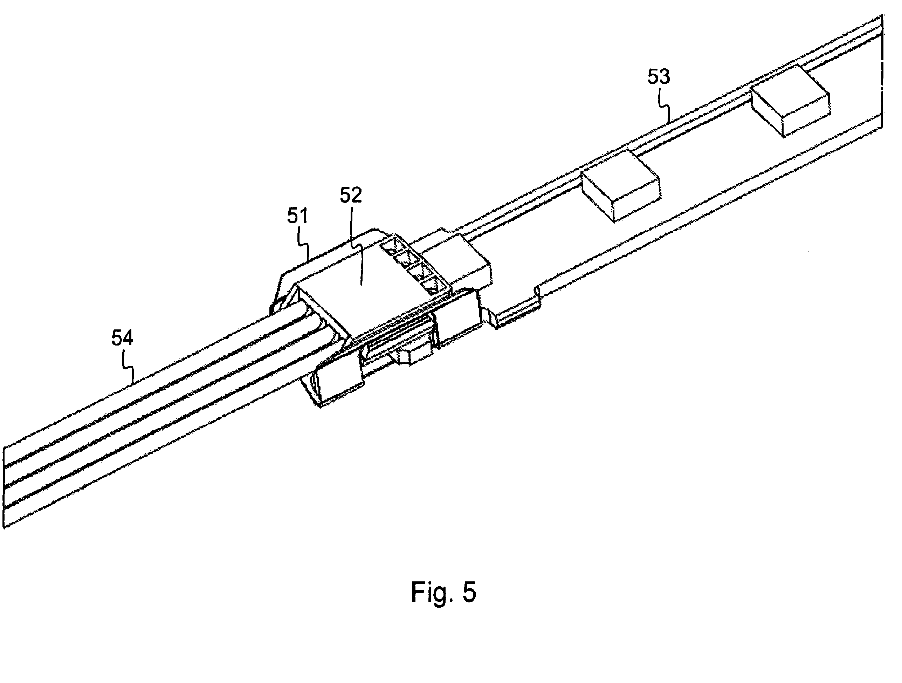

The connector 52 is a board-to-wire connector that enables to connect the contact paths of LED strip 53 through spring contacts with electrical power wires 54 that extend from the connector 52. The length C of the connector is smaller than the distance A in between neighbouring LEDs such that the equal distance between neighbouring LEDs can be respected, even if additional powering has to be foreseen. The connector 52 has a housing with side protrusions that engage with the recesses in clip 51 such that mechanical connectivity is ensured between the LED strip 53, clip 51, and connector 52, and the LED strip 53 and connector 52 cannot move or slide after being engaged with the clip (except for small relative movements within tolerance boundaries). This is illustrated by Fig. 5.

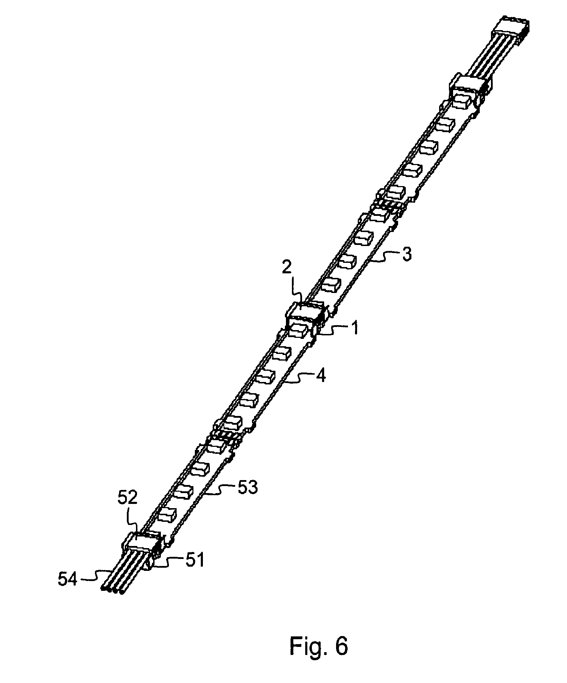

At last, Fig. 6 shows the installation of 4 LED strips, series connected. These LED strips include the LED strips 3, 4 and 53 from the previous drawings. The LED strips are interconnected through clips and connectors according to the present invention. One of them, i.e. connector 2 engaging with clip 1 to interconnect LED strip 3 and LED strip 4, is shown. The first and the fourth LED strip in Fig. 6 further are connected to electrical power wiring through a clip and connector as illustrated in Fig. 4. In particular, clip 51 and connector 52 are shown to connect LED strip 53 to electrical power wiring 54. Behind the second board-to-wire connector drawn at the top of Fig. 6, a further series connection of LED strips may be foreseen. At the top of Fig. 6, a board-to-wire-to-board connector is shown that will be used typically near corners to angle or curve the series connection of LED strips. The distance between any two neighbouring LEDs along the entire series connection of LED strips remains constant, e.g. 20 millimeters, such that a pattern with evenly distributed light intensity is generated. No dark spots or zones with lower light intensity appear in the pattern. In addition, if one of the LEDs is defect, the corresponding LED strip can be removed and replaced manually without risk for damaging the other LED strips. This is made possible by opening the clips left and right of the defect LED strip such that the corresponding connectors automatically disengage from the clips. The defect LED strip thereafter can be removed manually through a small movement or force, substantially perpendicular to the axes of the LED strip, without having to detach the clips from the surface and without risk for damaging neighbouring LED strips since these neighbouring LED strips remain in position. The repaired LED strip or a new LED strip will replace the defect LED strip. The installation thereof is similar to the above described installation of LED strips: the LED strip is foolproof positioned in the clips left and right. The LED strips are held in position through the recesses in the clips and LED strip substrates. The installer engages the connectors with the clips as a result of which electrical and mechanical interconnectivity is guaranteed.

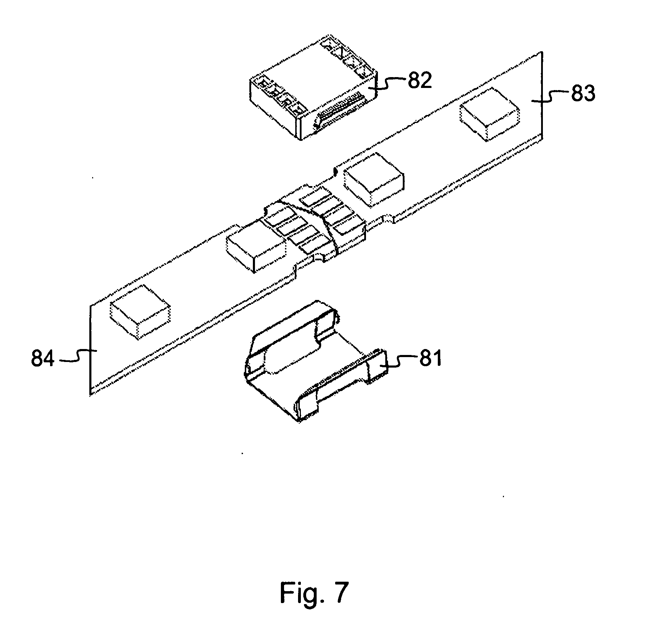

Fig. 7 shows a third embodiment of the assembly according to the present invention with a symmetric clip 81, a board-to-board connector 82, and two LED strips 83 and 84 with arrow-shaped break or cut lines. Thanks to the asymmetric break lines or cut ends of the LED strips 83 and 84, these LED strips will be dummy-proof positioned correctly against each other in the symmetric clip 81. Thereafter, the symmetric connector 82 shall mechanically and electrically connect the LED strips 83 and 84 when pushed to engage with the clip 81, through a force substantially perpendicular to the axes of the LED strips 83 and 84. A defect LED strip, e.g. LED strip 83 or 84, can be demounted and replaced by left and right opening the respective clips holding the defective LED strip. The defective LED strip can be replaced without having to remove any other LED strip and without damaging the surface or means holding the LED strip. Obviously, instead of arrow-shaped cutting lines or break lines, the LED strips may be provided with any other type of cutting lines or break lines that orientate neighbouring LED strips uniquely such that the mounting thereof becomes foolproof.

Essential to the invention is the asymmetric structure or sizing of the clip, connector or conductors to ensure that the conductors to be interconnected are foolproof positioned in the right direction. In addition, the clip and connector according to the invention are advantageous over the prior art in that they enable full manual mounting through a movement or force, substantially perpendicular to the axes of the LED strips, without the need for dedicated tools. The demounting is done through opening the clip left and right. When used to connect LED strips, the clip and connector provide additional benefits such as flexibility in connecting powering wires at different positions per strip without the need for additional parts or tools, and the ability to maintain an even, equidistant distribution of the LEDs, leaving no gaps, dark spots or zones with reduced light intensity in a pattern.

As explained above, the clip may be provided with double-sided tape or screw holes such that the clips can be fixed to the surface rather than the conductors themselves. This way, installation is made less cumbersome, and repair of defect conductors is made possible without a risk for damage to the conductors or connector. Possibly, the clip, connector and conductors will be mounted in a fitting like for instance an extrusion guide or profile.

The clip and connector are designed and dimensioned such that the clip provides strain relief. Even during the installation process, the clip maintains the conductors in position and avoids sliding or moving of the conductors such that security requirements are met. The clip in addition provides the necessary rigidity and mechanical strength to the assembly when mounted.

Additional flexibility can be obtained by marking the conductors with cutting marks. This way, the length of the conductors can be adapted to the specific needs, e.g. the length of a wall or closet whereon the LED strips will be mounted, the size of a ceiling or desk whereon LED strips will be used to generate a certain light pattern.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claim are therefore intended to be embraced therein. In other words, it is contemplated to cover any and all modifications, variations or equivalents that fall within the scope of the basic underlying principles and whose essential attributes are claimed in this patent application. The assembly according to the present invention for instance may but not necessarily has to include the conductors. The conductors may be LED strips as in the above examples, but can alternatively be any type of conductors that have to be connected electrically and mechanically. It will furthermore be understood by the reader of this patent application that the words "comprising" or "comprise" do not exclude other elements or steps, that the words "a" or "an" do not exclude a plurality, and that a single elements, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. An assembly comprising:
- a first conductor (3; 53) and a second conductor (4; 54), and
- a connector (2; 52) which provides electrical and mechanical connectivity between said first conductor (3; 53) and said second conductor (4; 54) ;
**CHARACTERIZED IN THAT** :
the assembly further comprises a clip (1; 51) adapted to position at least said first conductor (3; 53) and adapted to maintain at least said first conductor (3; 53) in position, the connector (2; 52) being adapted to engage with said clip (1; 51), and
wherein at least one of said clip (1; 51), said connector (2; 52) and said conductors (3; 53, 4; 54), have an asymmetric structure adapted to foolproof position and connect said first conductor (3; 53) and said second conductor (4; 54).

2. An assembly according to claim 1,
**CHARACTERIZED IN THAT**:
- said first conductor comprises a first Light Emitting Diode strip or first LED strip (3);
- said second conductor comprises a second Light Emitting Diode or second LED strip (4); and
- said clip (2), said first LED strip (3) and said second LED strip (4) are adapted to foolproof position both said first LED strip (3) and said second LED strip (4) and are adapted to maintain both said first LED strip (3) and said second LED strip (4) in position.

3. An assembly according to claim 1, **CHARACTERIZED IN THAT**:
- said first conductor comprises a first Light Emitting Diode strip or first LED strip (53); and
- said second conductor comprises electrical power wires (54).

4. An assembly according to claim 2 or claim 3,
**CHARACTERIZED IN THAT** said first LED strip (3; 53) and said second LED strip (4) comprise one or more visible marks indicative for one or more cutting sections.

5. An assembly according to claim 4,
**CHARACTERIZED IN THAT** said connector (2; 52) has a length (B; C) that is smaller than the distance (A) between neighbouring LEDs on said first LED strip (3; 53) and said second LED strip (4; 54).

6. An assembly according to claim 1,
**CHARACTERIZED IN THAT** said assembly comprises means for mounting said clip (1; 51) on a surface.

7. An assembly according to claim 1,
**CHARACTERIZED IN THAT** said clip (1; 51) and connector (2; 52) are adapted to engage and disengage manually, without tools.

8. An assembly according to claim 1,
**CHARACTERIZED IN THAT** said clip (1; 51) is made of a rigid material such as spring steel.

9. An assembly according to claim 1,
**CHARACTERIZED IN THAT** said clip (1) comprises:
- a bottom plate (11);
- a first side wall (12) with first recess (14) for positioning said first conductor (3); and
- a second side wall (13) with second recess (15), for positioning said first conductor (3),
wherein said first side wall (12) and said second side wall (13) have different sizes or geometries.

10. An assembly according to claim 1,
**CHARACTERIZED IN THAT** I said first conductor (3) comprises a substrate (31) with first cut-out (32) and opposing second cut-out (33), said first cut-out (32) and said second cut-out having (33) different sizes or geometries.

11. Method for foolproof connecting a first conductor (3; 53) and a second conductor (4; 54), said method comprising the steps of:
- providing a clip (1; 51);
- positioning at least said first conductor (3; 53) in said clip (1; 51);
- maintaining at least said first conductor (3; 53) in position through said clip (1; 51) and
- engaging a connector (2; 52) with said clip (1; 51), thereby providing mechanical and electrical connectivity between said first conductor (3; 53) and a second conductor (4; 54),
wherein at least one of said clip (1; 51), said connector (2; 52) and said conductors (3; 54, 4; 54) have an asymmetric structure for foolproof positioning and connecting said first conductor (3; 53) and said second conductor (4; 54).

## Patentansprüche

1. Eine Anordnung, bestehend aus:
- einem ersten elektrischen Leiter (3; 53) und einem zweiten elektrischen Leiter (4; 54) und
- einem Anschlussstecker (2; 52), der die elektrische und mechanische Verbindung zwischen dem oben genannten ersten Leiter (3; 53) und dem oben genannten zweiten Leiter (4; 54) herstellt;
**DADURCH GEKENNZEICHNET, DASS** die Anordnung außerdem mit einem Clip (1; 51) versehen ist, der mindestens den oben genannten ersten Leiter (3; 53) positioniert und den oben genannten ersten Leiter (3;53) in dieser Position hält, der Anschlussstecker (2; 52), der mit dem oben genannten Clip (1; 51) verbunden ist und bei dem mindestens einer der genannten Teile, also der Clip (1; 51), der genannte Anschlussstecker (2; 52) oder die genannten Leiter (3; 53, 4; 54) eine asymmetrische Struktur haben, die in einer absolut sicheren Position angebracht wurden und den oben genannten ersten Leiter (3; 53) und den oben genannten zweiten Leiter (4; 54) miteinander verbinden.

2. Eine Anordnung nach Anspruch 1, **DADURCH GEKENNZEICHNET, DASS**
- der oben genannte erste Leiter einen erster Leuchtdioden-Streifen bzw. einen ersten LED-Streifen enthält (3);
- der oben genannte zweite Leiter einen zweiten Leuchtdioden-Streifen bzw. einen zweiten LED-Streifen enthält (4); und
- der oben genannte Clip (2), der genannte erste LED Streifen (3) und der genannte zweite LED Streifen (4) angepasst sind, um eine absolut sichere Position des genannten ersten LED Streifens (3) und des genannte zweiten LED Streifens (4) zu gewährleisten und um sowohl den genannten ersten LED Streifen (3) als auch den genannten zweiten LED Streifen (4) in dieser Position zu halten.

3. Eine Anordnung nach Anspruch 1, **DADURCH GEKENNZEICHNET, DASS**
- der oben genannte erste Leiter einen ersten Leuchtdioden-Streifen bzw. einen ersten LED Streifen (53) enthält; und
- der oben genannte zweite Leiter elektrische Stromkabel (54) enthält.

4. Eine Anordnung nach Anspruch 2 oder Anspruch 3,
**DADURCH GEKENNZEICHNET, DASS** der oben genannte erste LED Streifen (3; 53) und der oben genannte zweite LED Streifen (4) einen oder mehrere sichtbare Markierungen enthalten, die auf eine oder mehrere Schnittstellen hinweisen.

5. Eine Anordnung nach Anspruch 4,
**DADURCH GEKENNZEICHNET, DASS** der oben genannte Anschlussstecker (2; 52) eine Länge (B; C) hat, die kleiner als der Abstand (A) zwischen den benachbarten LEDs auf dem oben genannten erste LED Streifen (3; 53) und dem oben genannten zweiten LED Streifen (4; 54) ist.

6. Eine Anordnung nach Anspruch 1,
**DADURCH GEKENNZEICHNET, DASS** die oben genannte Anordnung Vorrichtungen enthält, um den oben genannten Clip (1; 51) auf einer Oberfläche aufstellen zu können.

7. Eine Anordnung nach Anspruch 1,
**DADURCH GEKENNZEICHNET, DASS** oben genannter Clip (1; 51) und der Anschlussstecker (2; 52) angepasst wurden, um manuell ohne irgendwelche Werkzeuge ein- und ausgeschaltet werden zu können.

8. Eine Anordnung nach Anspruch 1,
**DADURCH GEKENNZEICHNET, DASS** oben genannter Clip (1; 51) aus einem unbeugsamen Material, wie zum Beispiel Federstahl, hergestellt wurde.

9. Eine Anordnung nach Anspruch 1,
**DADURCH GEKENNZEICHNET, DASS** oben genannter Clip (1) folgendes enthält:
- ein Bodenblech (11);
- eine erste Längsseite (12) mit einer ersten Aussparung (14), um den oben genannten ersten Leiter (3) anzubringen; und
- eine zweite Längsseite (13) mit einer zweiten Aussparung (15), um den oben genannten ersten Leiter (3) anzubringen,
wobei die oben genannte erste Längsseite (12) und die oben genannte zweite Längsseite (13) verschiedene Größen oder Geometrie haben.

10. Eine Anordnung gemäß Anforderung 1,
**DADURCH GEKENNZEICHNET, DASS** oben genannter erster Leiter (3) ein Trägermaterial (31) mit einer ersten Aussparung (32) und einer gegenüberliegenden zweiten Aussparung (33) enthält, wobei die oben genannte erste Aussparung (32) und die oben genannte zweite Aussparung (33) verschiedene Größen und Geometrie besitzen.

11. Methode zur absolut sicheren Verbindung eines ersten Leiters (3; 53) mit einem zweiten Leiter (4; 54), die aus den folgenden Schritten besteht:
- Bereitstellung eines Clips (1; 51);
- Anbringung mindestens eines solchen Leiters (3; 53) in einen solchen Clip (1; 51);
- Das Halten von mindestens eines solchen Leiters (3; 53) in Position durch einen solchen Clip (1; 51) und
- Verbindung eines Anschlusssteckers (2; 52) mit oben genanntem Clip (1; 51), unter Herstellung einer elektrischen Verbindung zwischen dem ersten Leiter (3; 53) und einem zweiten Leiter (4; 54),
wobei mindestens einer dieser Teile, der Clip (1; 51), der Anschlussstecker (2; 52) oder die Leiter (3; 54, 4; 54) eine asymmetrische Struktur für eine absolut sichere Positionierung besitzen und den oben genannten ersten Leiter (3; 53) mit dem oben genannten zweiten Leiter (4; 54) verbinden.

## Revendications

1. Un ensemble comprenant:
- un premier conducteur (3; 53) et un deuxième conducteur (4; 54), et
- un connecteur (2; 52) qui permet de raccorder électriquement et mécaniquement ledit premier conducteur (3; 53) et ledit deuxième conducteur (4; 54) ;
CHARACTERISE EN CE QUE l'ensemble comprend en outre un serre-câble (1; 51) permettant de positionner au moins ledit premier conducteur (3; 53) et de maintenir au moins ledit premier conducteur (3; 53) en position, le connecteur (2; 52) pouvant être engagé dans ledit serre-câble (1; 51), sachant que parmi ledit serre-câble (1; 51), ledit connecteur (2; 52) et lesdits conducteurs (3; 53, 4; 54), au moins l'un d'entre eux présente une structure asymétrique qui permet de positionner et de raccorder ledit premier conducteur (3; 53) et ledit deuxième conducteur (4; 54) sans se tromper.

2. Un ensemble selon la revendication 1, CHARACTERISE EN CE QUE
- ledit premier conducteur comprend une première réglette à diode électroluminescente ou première réglette LED (3) ;
- ledit deuxième conducteur comprend une deuxième réglette à diode électroluminescente ou deuxième réglette LED (4) ; et
- ledit serre-câble (2), ladite première réglette LED (3) et ladite deuxième réglette LED (4) permettent de positionner sans se tromper ladite première réglette LED (3) et ladite deuxième réglette LED (4) et de maintenir en position ladite première réglette LED (3) et ladite deuxième réglette LED (4).

3. Un ensemble selon la revendication 1, CHARACTERISE EN CE QUE
- ledit premier conducteur comprend une première réglette à diode électroluminescente ou première réglette LED (53); et
- ledit deuxième conducteur comprend des fils d'alimentation électrique (54).

4. Un ensemble selon la revendication 2 ou revendication 3, CHARACTERISE EN CE QUE ladite première réglette LED (3; 53) et ladite deuxième réglette LED (4) comportent un ou plusieurs repères visibles qui identifient une ou plusieurs longueurs de découpe.

5. Un ensemble selon la revendication 4,
CHARACTERISE EN CE QUE ledit connecteur (2; 52) a une longueur (B; C) inférieure à la distance (A) comprise entre les LED voisines sur ladite première réglette LED (3; 53) et ladite deuxième réglette LED (4; 54).

6. Un ensemble selon la revendication 1,
CHARACTERISE EN CE QUE ledit ensemble permet de monter ledit serre-câble (1:51) sur une surface.

7. Un ensemble selon la revendication 1,
CHARACTERISE EN CE QUE ledit serre-câble (1; 51) et le connecteur (2; 52) peuvent être engagés et désengagés manuellement, sans outillage.

8. Un ensemble selon la revendication 1,
CHARACTERISE EN CE QUE ledit serre-câble (1; 51) est constitué d'un matériau rigide tel que de l'acier à ressort.

9. Un ensemble selon la revendication 1,
CHARACTERISE EN SE QUE ledit serre-câble (1) comprend:
- une embase (11);
- une première paroi latérale (12) comportant une première cavité (14) pour positionner ledit premier conducteur (3); et
- une deuxième paroi latérale (13) comportant une deuxième cavité (15), pour positionner ledit premier conducteur (3),
ladite première paroi latérale (12) et ladite deuxième paroi latérale (13) ayant des tailles ou des géométries différentes.

10. Un ensemble selon la revendication 1,
CHARACTERISE EN SE QUE ledit premier conducteur (3) comprend un substrat (31) comportant un premier évidement (32) situé en face d'un deuxième évidement (33), ledit premier évidement (32) et ledit deuxième évidement (33) ayant des tailles ou des géométries différentes.

11. Méthode pour raccorder sans se tromper un premier conducteur (3; 53) et un deuxième conducteur (4; 54), ladite méthode consistant à:
- disposer un serre-câble (1; 51);
- positionner au moins ledit premier conducteur (3; 53) dans ledit serre-câble (1; 51);
- maintenir au moins ledit premier conducteur (3; 53) en position à l'aide dudit serre-câble (1; 51) et
- engager un connecteur (2; 52) dans ledit serre-câble (1; 51), ce qui permet de raccorder ledit premier conducteur (3; 53) et ledit deuxième conducteur (4; 54),
sachant que parmi ledit serre-câble (1; 51), ledit connecteur (2; 52) et lesdits conducteurs (3; 54, 4; 54) au moins l'un d'entre eux présente une structure asymétrique qui permet de positionner et de raccorder ledit premier conducteur (3; 53) et ledit deuxième conducteur (4; 54) sans se tromper.
